(19) Europäisches Patentamt
European Patent Office
Office européen des brevets

(11) **EP 0 563 633 B1**

(12) **EUROPÄISCHE PATENTSCHRIFT**

(45) Veröffentlichungstag und Bekanntmachung des Hinweises auf die Patenterteilung:
**27.01.1999   Patentblatt 1999/04**

(51) Int Cl.⁶: **H03K 17/13**

(21) Anmeldenummer: **93103737.8**

(22) Anmeldetag: **09.03.1993**

(54) **Schaltungsanordnung zur Phasen-Abschnitt-Steuerung**

Circuit arrangement for phase angle control

Circuit de contrôle de l'angle de phase

(84) Benannte Vertragsstaaten:
**DE FR GB IT**

(30) Priorität: **02.04.1992   DE 4210993**

(43) Veröffentlichungstag der Anmeldung:
**06.10.1993   Patentblatt 1993/40**

(73) Patentinhaber: **TEMIC Semiconductor GmbH 74072 Heilbronn (DE)**

(72) Erfinder:
• **Nutz, Karl-Diether W-7101 Oedheim (DE)**
• **Gruber, Berthold W-6927 Bad Rappenau 8 (DE)**

(74) Vertreter: **Maute, Hans-Jürgen, Dipl.-Ing. et al Daimler-Benz Aktiengesellschaft, FTP/H, Postfach 35 35 74025 Heilbronn (DE)**

(56) Entgegenhaltungen:
EP-A- 301 815          EP-A- 367 984
EP-A- 380 833          EP-A- 401 587
GB-A- 2 200 006

• **TECHNISCHE RUNDSCHAU Bd. 66, Nr. 34, 1. Januar 1974, BERN,CH Seite 25 VON KARL-D.NUTZ 'EIN MONOLITHISCH INTEGRIERTER NULLSPANNUNGSSCHALTER'**

**Beschreibung**

Die Erfindung betrifft eine Schaltungsanordnung gemäß dem Oberbegriff des Patentanspruchs 1.

Eine derartige Schaltungsanordnung ist beispielsweise aus der GB 2 200 006 bekannt. Bei der bekannten Schaltungsanordnung wird, um die Leistungsversorgung eines Verbrauchers definiert zeitlich zu steuern, der Laststrom durch den Verbraucher mit Hilfe eines Triacs als Halbleiterschaltelement erst bei einem bestimmten Phasenwinkel nach einem Nulldurchgang der Netz-Wechselspannung durch einen Steuerimpuls eingeschaltet und beim nächsten Nulldurchgang wieder selbsttätig abgeschaltet. Eine erartige Steuerung wird üblicherweise als Phasen-Anschnitt-Steuerung bezeichnet. Nachteilig bei der Phasen-Anschnitt-Steuerung ist der geringe Leistungsfaktor, da selbst bei ohmscher Last immer ein gewisser - bei großen Phasenwinkeln ein hoher - Blindleistungsanteil vorhanden ist. Zudem gibt es bei der Phasen-Anschnitt-Steuerung oftmals ein Haltestrom-Problem, da ein ungewolltes Ausschalten des Halbleiterschalterelements - insbesondere bei kleinen Lastströmen - verhindert werden muß. Schließlich ist bei der Phasen-Anschnitt-Steuerung wegen des beim Einschalten des Laststroms auftretenden Spannungssprungs und der damit verbundenen HF-Problematik ein hoher Entstöraufwand erforderlich.

Im Gegensatz zur Phasen-Anschnitt-Steuerung wird bei der Phasen-Abschnitt-Steuerung, wie sie aus der EP 0 311 995 A2 bekannt ist, die Leistungsversorgung des Verbrauchers mit Hilfe von (voll-abschaltbaren) Halbleiterschaltelementen (vorzugsweise Feldeffekttransistoren) derart gesteuert, daß der Laststrom im Nulldurchgang der Netz-Wechselspannung eingeschaltet und bei einem bestimmten Phasenwinkel (beim Erreichen des Sollstroms) wieder abgeschaltet wird. Da hierdurch der Blindleistungsanteil minimiert wird, ist der Wirkleistungsanteil maximal und somit ein optimaler Wirkungsgrad gegeben; da kein Spannungssprung beim Einschalten des Laststroms auftritt und die Abschaltflanke gesteuert ablaufen kann, werden keine Entstörmaßnahmen benötigt.

Der Erfindung liegt die Aufgabe zugrunde, eine Schaltungsanordnung gemäß dem Oberbegriff des Patentanspruchs 1 anzugeben, die einfach und mit einer geringen Anzahl an Bauelementen herstellbar ist.

Diese Aufgabe wird gemäß der Erfindung durch die Merkmale im Kennzeichen des Patentanspruchs 1 gelöst. Vorteilhafte Weiterbildungen der Schaltungsanordnung ergeben sich aus den Unteransprüchen.

Von der erfindungsgemäßen Schaltungsanordnung muß gewährleistet werden, daß zur Phasen-Abschnitt-Steuerung der Laststrom vom Halbleiterschaltelement einerseits präzise im Nulldurchgang der Netzspannung eingeschaltet und andererseits nach der extern vorgebbaren Stromflußzeit (dem Phasenabschnitt-Zeitintervall) mit definierter Flanke abgeschaltet wird. Zur zeitlichen Ablaufsteuerung beim Einschalten bzw. Ausschalten des Laststroms wird bei der vorgestellten Schaltungsanordnung vorteilhafterweise ein zeitbestimmendes Bauelement eingesetzt; die Ansteuerung des zeitbestimmenden Bauelements bzw. die Auswertung der Zeitabläufe erfolgt durch Schaltungsteile eines Integrierten Schaltkreises - die Ansteuerung bsp. durch eine Synchronisierschaltung und Ansteuerschaltung und die Auswertung beispielsweise durch eine Auswerteschaltung. Das zeitbestimmende Bauelement ist vorzugsweise ein im Schaltkreis integrierter oder ein extern angeschlossener Kondensator, durch dessen Ladezustand eine Rampenspannung generiert wird. Der Ladezustand des Kondensators und damit das zeitliche Verhalten der Rampenspannung wird bsp. von einem umschaltbaren Stromgenerator gesteuert und der Zeitverlauf bsp. mittels Komparatoren ausgewertet.

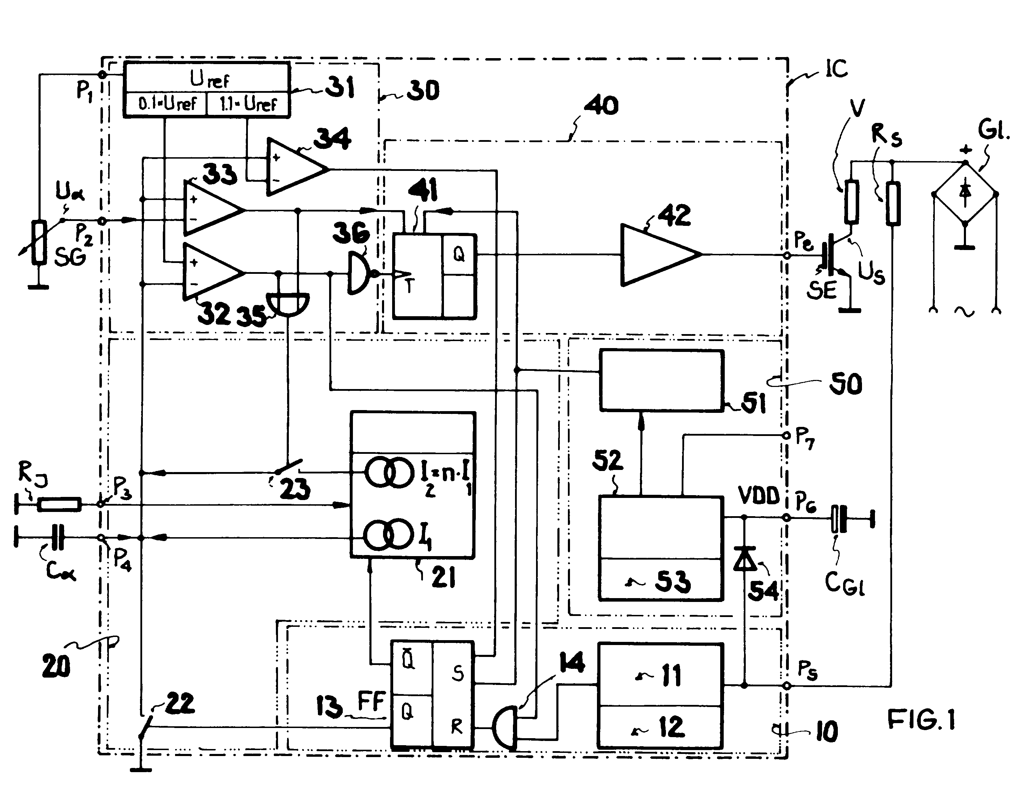

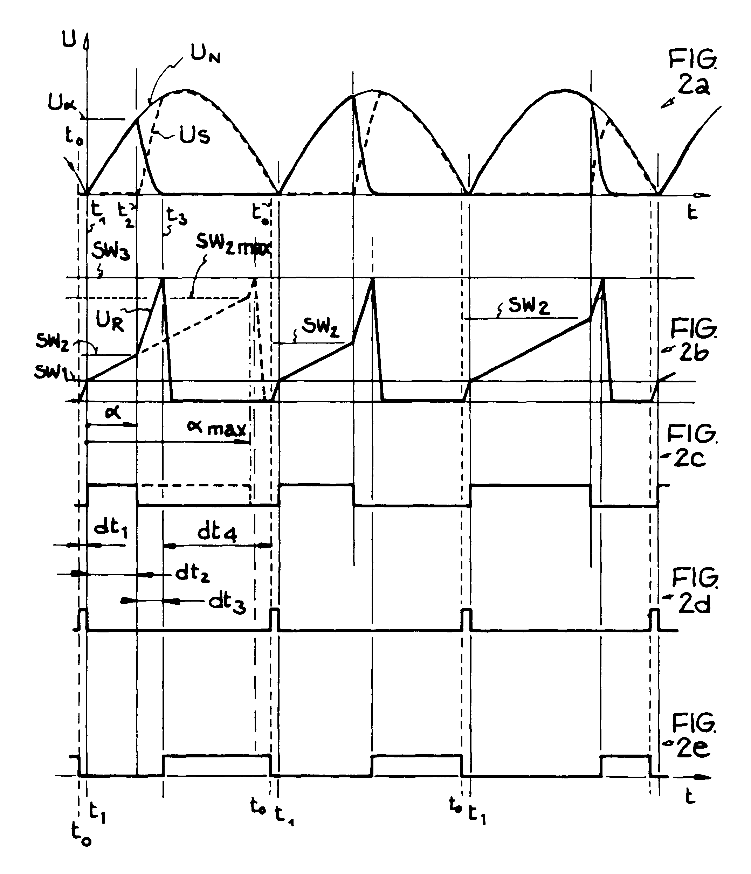

Die Schaltungsanordnung zur Phasen-Abschnitt-Steuerung wird im folgenden anhand der Figur 1 (diese zeigt den Integrierten Schaltkreis mit externen Bauelementen) und die Wirkungsweise der Phasen-Abschnitt-Steuerung anhand der Figur 2 (diese zeigt verschiedene Zeitdiagramme) näher beschrieben.

In der Figur 1 sind folgende Komponenten dargestellt:

- der Integrierte Schaltkreis IC mit den 8 Anschlußpins $P_1$-$P_8$ ($P_1$: Referenzspannungs-Ausgang, $P_2$: Steuer-Eingang, $P_3$: Justier-Eingang, $P_4$: Steuer-Ausgang/Rampen-Eingang, $P_5$: Synchronisier-/Versorgungs-Eingang, $P_6$: Kondensator-Ausgang, $P_7$: Bezugspotential, $P_8$: Ansteuer-Ausgang) und den Schaltungsteilen Synchronisierschaltung 10, Ansteuerschaltung 20, Auswerteschaltung 30, Endstufe 40 und Spannungsversorgungsschaltung 50

- das am Ansteuer-Ausgang $P_8$ des Integrierten Schaltkreises IC angeschlossene Halbleiterschaltelement SE, das den Stromfluß durch den mit Laststrom zu versorgenden Verbraucher V steuert; das Halbleiterschaltelement SE kann beispielsweise ein Bipolartransistor oder ein MOS-Feldeffekttransistor sein - vorzugsweise wird jedoch als Halbleiterschaltelement SE ein IGBT-Transistor eingesetzt (Spannung $U_S$), da dieser durch Steuerspannungen quasi leistungslos angesteuert und auf definierte Weise abgeschaltet werden kann

- das mit dem Referenzspannungs-Ausgang $P_1$ und dem Steuer-Eingang $P_2$ verbundene Stellglied SG (beispielsweise ein Potentiometer), das eine den Phasenwinkel $\alpha$ und damit die Stromflußdauer bestimmende Steuerspannung $U_\alpha$ vorgibt; die Steuerspannung $U_\alpha$ kann durch das Stellglied SG extern zwischen einer Minimalspannung $U_{\alpha,min}$ und einer Maximalspannung $U_{\alpha,max}$ variiert werden

- der am Justier-Eingang $P_3$ angeschlossene Wi-

derstand $R_J$, durch den eine präzise Stromreferenz für die Ansteuerschaltung 20 eingestellt wird

- der am Steuer-Ausgang bzw. Rampen-Eingang $P_4$ extern oder intern angeschlossene Kondensator $C_\alpha$ als zeitbestimmendes Bauelement, durch den (vermöge der am Kondensator $C_\alpha$ anliegenden Rampenspannung $U_R$) die zeitlichen Abläufe der Phasen-Abschnitt-Steuerung gesteuert werden; aufgrund der vorteilhaften Ansteuerung des Kondensators $C_\alpha$ durch Schaltungsteile des ICs können mit dem Kondensator $C_\alpha$ als einzigem zeitbestimmenden Bauelement unterschiedliche Zeitverläufe präzise erfaßt und ausgewertet werden

- der am Kondensator-Ausgang $P_6$ angeschlossene Kondensator $C_{GL}$ zur Glättung der Versorgungsspannung

- der Gleichrichter GI zur Gleichrichtung der Netz-Wechselspannung und der mit dem Synchronisier-Eingang $P_5$ verbundene Synchronisier-Widerstand $R_S$.

Der Integrierte Schaltkreis IC umfaßt folgende Schaltungsteile:

- Die Synchronisierschaltung 10 mit dem Synchronisationsglied 11, mit dem Null-Detektor 12, mit dem Speicher-Flip-Flop 13 (beispielsweise ein RS-Flip-Flop) und mit dem UND-Gatter 14; durch die Synchronisierschaltung 10 wird die Nullpunktserkennung der Netz-Wechselspannung $U_N$ und die Synchronisierung der Rampenspannung $U_R$ an die Netz-Wechselspannung $U_N$ vorgenommen.

- Die Ansteuerschaltung 20 mit dem vom Speicher-Flip-Flop 13 aktivierbaren/deaktivierbaren und über den Justier-Eingang $P_3$ verstellbaren Stromgenerator 21, über dessen Stromausgang durch Aufladen des Kondensators $C_\alpha$ die Rampenspannung $U_R$ erzeugt wird, mit dem ersten Schalter 22 zur Aktivierung/Deaktivierung des Zeitglieds $C_\alpha$, und mit dem zweiten Schalter 23 zur Bereichsumschaltung des Stromgenerators 21 vom Strom $I_1$ auf den wesentlich größeren Strom $I = I_1 + I_2$ ($I_2 = n \times I_1$, $n > 1$); mittels der Ansteuerschaltung 20 können somit durch Generierung unterschiedlich steiler Rampenspannungen $U_R$ am Kondensator $C_\alpha$ unterschiedliche Zeitverläufe eingestellt bzw. vorgegeben werden.

- Die Auswerteschaltung 30 mit dem am Referenzspannungs-Ausgang $P_1$ angeschlossenen Referenzspannungsgenerator 31, der die Referenzspannung $U_{Ref}$ erzeugt, den Komparatoren 32, 33, 34 zum Festlegen von Schwellwerten $SW_1$, $SW_2$, $SW_3$ und den Logikgattern 35, 36 zum Verarbeiten der Signale an den Komparator-Ausgängen; durch die Auswerteschaltung 30 werden die bei der Phasen-Abschnitt-Steuerung auftretenden Spannungspegel (insbesondere die Rampenspannungen) überwacht, mit den Schwellwerten $SW_1$, $SW_2$ und $SW_3$ verglichen und in Abhängigkeit dieses Vergleichs bestimmte Reaktionen ausgelöst.

- Die Endstufe 40 mit dem von der Auswerteschaltung 30 angesteuerten Takt-Flip-Flop 41 und dem mit dem Takt-Flip-Flop 41 verbundenen Ausgangsverstärker 42; dessen Ausgang ist an den Ansteuer-Ausgang $P_8$ und demzufolge an das Halbleiterschaltelement SE angeschlossen.

- Die Spannungsversorgungsschaltung 50 mit dem Unterspannungserkennungselement 51 ("Power on"), dem Versorgungsteil 52, dem Begrenzerteil 53 und der Begrenzer-Diode 54.

Der zeitliche Ablauf der Phasen-Abschnitt-Steuerung und deren Ablaufsteuerung wird anhand der in der Figur 2 dargestellten Zeitdiagramme erläutert. In der Figur 2a ist der Verlauf der (gleichgerichteten) Netz-Wechselspannung $U_N$ und der Spannung $U_S$ am Halbleiterschaltelement SE, in der Figur 2b der Verlauf der vom Ausgangsstrom des Stromgenerators erzeugten Rampenspannung $U_R$ dargestellt; die Figuren 2c, 2d und 2e zeigen die Logikpegel am Ansteuer-Ausgang $P_8$, am Null-Detektor 12 und am Ausgang des Synchronisationsglieds 11.

Jede Halbwelle der Netz-Wechselspannung $U_N$ ist gemäß Figur 2 in 4 charakteristische Zeitabschnitte gegliedert:

- Das Zeitintervall $dt_1$ vom Zeitpunkt $t_0$ (Nulldurchgangs-Erkennung) bis zum Zeitpunkt $t_1$ (tatsächlicher Nulldurchgang) ist das "Kompensations-Zeitintervall" zur Kompensierung des zeitlichen Versatzes zwischen Erkennung und Stattfinden des Nulldurchgangs der Netz-Wechselspannung $U_N$.

Der Null-Detektor 12 generiert (Figur 2d) zum Zeitpunkt $t_0$ kurz vor dem Nulldurchgang der Netz-Wechselspannung $U_N$ einen Impuls (logische "1"), durch den über das UND-Gatter 14 ein Reset des Speicher-Flip-Flops 13 erzeugt wird. Der Ausgang Q des Speicher-Flip-Flops 13 wird auf "0" geschaltet, und der erste Schalter 22 geöffnet; gleichzeitig wird der Ausgang $\overline{Q}$ des Speicher-Flip-Flops 13 auf "1" geschaltet, wodurch der Stromgenerator 21 aktiviert wird. Durch das Ausgangssignal des ersten Komparators 32 (logische "1", wenn die Rampenspannung $U_R$ gemäß Figur 2b kleiner als der Schwellwert $SW_1$ ist) wird der zweite Schalter 23 über das ODER-Gatter 35 geschlossen und der Bereich des Stromgenerators 21 umgeschaltet; dieser lädt den Kondensator $C_\alpha$ mit dem Summenstrom $I = I_1 + I_2 = (n + 1) \times I_1$ auf und erzeugt somit einen steilen Anstieg der Rampenspannung $U_R$.

Die Länge des Kompensations-Zeitintervalls $dt_1$ wird durch die beiden Eingangsspannungen am ersten Komparator 32 - Schwellwert $SW_1$ und Rampenspannung $U_R$ - bestimmt; der Schwellwert $SW_1$ des ersten Komparators 32 liegt weit unterhalb der vom Referenzspannungsgenerator 31 vorgegebenen Referenzspannung $U_{Ref}$ (beispielsweise $SW_1$ = 0,1 x $U_{Ref}$, also $SW_1$ = 0,5 V bei einer Referenzspannung $U_{Ref}$ = 5 V) und wird somit bei dem steilen Spannungsanstieg der Rampenspannung $U_R$ schnell erreicht.

- Das Zeitintervall $dt_2$ vom Zeitpunkt $t_1$ (Ablauf des Kompensations-Zeitintervalls $dt_1$) bis zum Zeitpunkt $t_2$ (die Rampenspannung $U_R$ am Kondensator $C_\alpha$ erreicht die am Steuer-Eingang $P_2$ vorgegebene Steuerspannung $U_\alpha$) ist das Phasenabschnitt-Zeitintervall, in dem der Laststrom für den Verbraucher V fließt (Figur 2c).

Zum Zeitpunkt $t_1$ erreicht die Rampenspannung $U_R$ den Schwellwert $SW_1$ des ersten Komparators 32 (Figur 2b), wodurch dessen Ausgang umgeschaltet wird (logische "0"): einerseits wird dadurch über das ODER-Gatter 35 der zweite Schalter 23 geöffnet und der Stromgenerator 21 auf den geringen Ausgangsstrom $I_1$ geschaltet, so daß für den zweiten Komparator 33 ein flacher Spannungsanstieg der Rampenspannung $U_R$ vorgegeben wird; andererseits wird über den Inverter 36 (Ausgang = "1"), das Takt-Flip-Flop 41 und die Verstärkerstufe 42 das Halbleiterschaltelement SE aktiviert (der IGBT-Transistor wird durchgeschaltet), so daß der Laststrom durch den Verbraucher V zu fließen beginnt. Zum Zeitpunkt $t_2$ erreicht die Rampenspannung $U_R$ den über die Steuerspannung $U_\alpha$ vorgegebenen Komparator-Schwellwert $SW_2$ (Figur 2b); der Ausgang des zweiten Komparators 33 wird umgeschaltet (logische "1"), und über das Takt-Flip-Flop 41 und den Verstärker 42 das Halbleiterschaltelement SE deaktiviert (der IGBT-Transistor wird gesperrt); gleichzeitig wird zum Zeitpunkt $t_2$ über das ODER-Gatter 35 der zweite Schalter 23 geschlossen und somit der Stromgenerator 21 auf den Summenstrom $I = I_1 + I_2$ umgeschaltet. Die Länge des Phasenabschnitt-Zeitintervalls $dt_2$ wird durch die beiden Eingangsspannungen des zweiten Komparators 33 - die die Höhe des zweiten Schwellwerts $SW_2$ festlegende Steuerspannung $U_\alpha$ einerseits und die Rampenspannung $U_R$ andererseits - vorgegeben: der minimale Phasenabschnitt $\alpha_{min}$ entspricht der minimalen Steuerspannung $U_{\alpha,min}$ - $SW_1$ (Schwellwert des ersten Komparators 32), der maximale Phasenabschnitt $\alpha_{max}$ entspricht der maximalen Steuerspannung $U_{\alpha,max}$ = $U_{Ref}$, die den maximal möglichen zweiten Schwellwert $SW_{2,max}$ vorgibt (die maximalen Werte sind in Figur 2b und Figur 2c gestrichelt eingezeichnet).

- Das Zeitintervall $dt_3$ vom Zeitpunkt $t_2$ bis zum Zeitpunkt $t_3$ ist ein "Sicherheits-Zeitintervall" beim Abschalten des Laststroms; im Zeitintervall $dt_2$ wird die Endstufe 40 durch den Reset-Impuls des Flip-Flop 41 sicher deaktiviert, um eine Rückwirkung des Ausschaltvorgangs des Halbleiterschaltelements SE (aufgrund der ansteigenden Spannung) auf die Schaltungsanordnung zu verhindern. Der zum Zeitpunkt $t_2$ auf den Summenstrom $I = I_1 + I_2$ umgeschaltete Stromgenerator 21 wird zum Zeitpunkt $t_3$ beim Erreichen des dritten Komparator-Schwellwerts $SW_3$ (Ausgang des dritten Komparators 34 = "0") über das Speicher-Flip-Flop 13 deaktiviert und gleichzeitig der Kondensator $C_\alpha$ über den ersten Schalter 22 kurzgeschlossen.

Die Länge des Sicherheits-Zeitintervalls $dt_3$ wird durch die beiden Eingangsspannungen am dritten Komparator 34 - Schwellwert $SW_3$ und (steile) Rampenspannung $U_R$ - bestimmt; der Schwellwert $SW_3$ liegt geringfügig über dem vom Referenzspannungsgenerator 31 vorgegebenen Wert der Referenzspannung $U_{Ref}$, beispielsweise $SW_3$ = 1,1 x $U_{Ref}$, und wird somit bei dem steilen Spannungsanstieg der Rampenspannung $U_R$ schnell erreicht.

Gleichzeitig wird zur Unterdrückung von Störimpulsen zum Zeitpunkt $t_2$ über den Ausgang des zweiten Komparators 33 und das UND-Gatter 14 die Synchronisierschaltung 10 deaktiviert auf somit die Freigabe für die Nullsynchronisierung gesperrt (Figur 2e); gemäß Figur 2e ist der Ausgang des Synchronisationsglieds 11 solange auf einer logischen "1" und die Synchronisierschaltung 10 dadurch deaktiviert, bis die Rampenspannung $U_R$ wieder unter den Schwellwert $SW_1$ des ersten Komparators 32 abgesunken ist.

- Im Zeitintervall $dt_4$ vom Zeitpunkt $t_3$ bis zum Zeitpunkt $t_0$ wird die nächste Periode der Halbwelle der Netz-Wechselspannung $U_N$ vorbereitet; der Kondensator $C_\alpha$ wird bei geschlossenem ersten Schalter 22 vollständig entladen und dadurch für den nächsten Phasenabschnitt - beispielsweise wie in der Figur 2 dargestellt mit einem anderen Phasenwinkel $\alpha$ - initialisiert.

## Patentansprüche

1. Schaltungsanordnung zur Steuerung des Stromflusses in einem von einem Halbleiterschaltelement (SE) angesteuerten Verbraucher (V) nach Maßgabe einer Netz-Wechselspannung ($U_N$), mit:

- einer Synchronisierschaltung (10) zur Nullpunktserkennung der Netz-Wechselspannung ($U_N$) und zur Synchronisierung einer Rampenspannung ($U_R$) an die Netz-Wechselspannung ($U_N$),

- einer Auswerteschaltung (30) zur Überwachung von bei der Steuerung auftretenden Spannungspegeln,

- einer Endstufe (40) zur Ansteuerung des Halbleiterschaltelements (SE),

- einem zeitbestimmenden Bauelement (C$_\alpha$)

- und einer Spannungsversorgungsschaltung (50),

dadurch gekennzeichnet, daß

- eine Ansteuerschaltung (20) zur Vorgabe unterschiedlicher Spannungsverläufe der Rampenspannung (U$_R$) vorgesehen ist,

- die Synchronisierschaltung (10), die Auswerteschaltung (30), die Endstufe (40), die Spannungsversorgungsschaltung (50) und die Ansteuerschaltung (20) in einem integrierten Schaltkreis (IC) angeordnet sind

- und der Stromfluß im Verbraucher (V) durch Phasen-Abschnitt-Steuerung auf einen bestimmten Phasenwinkel ($\alpha$) der Netz-Wechselspannung (U$_N$) begrenzt wird.

2. Schaltungsanordnung nach Anspruch 1, dadurch gekennzeichnet, daß das zeitbestimmende Bauelement ein Kondensator (C$_\alpha$) ist, durch dessen Ladezustand die Rampenspannung (U$_R$) gebildet wird.

3. Schaltungsanordnung nach Anspruch 2, dadurch gekennzeichnet, daß der Kondensator (C$_\alpha$) im integrierten Schaltkreis (IC) angeordnet ist.

4. Schaltungsanordnung nach Anspruch 2, dadurch gekennzeichnet, daß der Kondensator (C$_\alpha$) extern an einem als Steuer-Ausgang bzw. Rampen-Eingang dienenden Anschlußpin (P$_4$) des integrierten Schaltkreises (IC) angeschlossen ist.

5. Schaltungsanordnung nach einem der Ansprüche 1 bis 4, dadurch gekennzeichnet, daß ein zwischen einem als Steuer-Eingang dienenden Anschlußpin (P$_2$) und einem als Referenzspannungs-Ausgang dienenden Anschlußpin (P$_1$) des integrierten Schaltkreises (IC) geschaltetes Stellglied (SG) vorgesehen ist, das eine den Phasenwinkel ($\alpha$) bestimmende Steuerspannung (U$_\alpha$) generiert.

6. Schaltungsanordnung nach einem der Ansprüche 1 bis 5, dadurch gekennzeichnet, daß an einem als Justier-Eingang dienenden Anschlußpin (P$_3$) des integrierten Schaltkreises (IC) ein extern angeschlossener veränderbarer Widerstand (R$_J$) vorgesehen ist.

7. Schaltungsanordnung nach einem der Ansprüche 1 bis 6, dadurch gekennzeichnet, daß das Halbleiterschaltelement (SE) an einem als Ansteuer-Ausgang dienenden Anschlußpin (P$_8$) des integrierten Schaltkreises (IC) angeschlossen ist.

8. Schaltungsanordnung nach Anspruch 7, dadurch gekennzeichnet, daß das Halbleiterschaltelement (SE) ein IGBT-Transistor ist.

9. Schaltungsanordnung nach einem der vorangehenden Ansprüche, dadurch gekennzeichnet, daß die Synchronisierschaltung (10) ein Synchronisationsglied (11), einen Null-Detektor (12), ein Speicher-Flip-Flop (13) und ein UND-Gatter (14) aufweist.

10. Schaltungsanordnung nach einem der vorangehenden Ansprüche, dadurch gekennzeichnet, daß die Ansteuerschaltung (20) einen umschaltbaren Stromgenerator (21), einen ersten Schalter (22) und einen zweiten Schalter (23) aufweist.

11. Schaltungsanordnung nach Anspruch 10, dadurch gekennzeichnet, daß der Ausgang des Stromgenerators (21) schaltbar über den ersten Schalter (22) mit dem Kondensator (C$_\alpha$) verbunden ist.

12. Schaltungsanordnung nach Anspruch 10 oder 11, dadurch gekennzeichnet, daß der Ausgangsstrom des Stromgenerators (21) über den zweiten Schalter (23) von einem kleinen Ausgangsstrom (I$_1$) auf einen größeren Ausgangsstrom (I$_1$ + I$_2$) umschaltbar ist.

13. Schaltungsanordnung nach einem der Ansprüche 10 bis 12, dadurch gekennzeichnet, daß der Aktivierungs-/Deaktivierungs-Eingang des Stromgenerators (21) mit dem invertierenden Ausgang ($\overline{Q}$) des Speicher-Flip-Flops (14) verbunden ist.

14. Schaltungsanordnung nach einem der vorangehenden Ansprüche, dadurch gekennzeichnet, daß die Auswerteschaltung (30) einen Referenzspannungsgenerator (31), Komparatoren (32, 33, 34) mit unterschiedlichen Schwellwerten (SW$_1$, SW$_2$, SW$_3$) und zwei Logik-Gatter (35, 36) aufweist.

15. Schaltungsanordnung nach Anspruch 14, dadurch gekennzeichnet, daß jeweils ein Eingang der Komparatoren (32, 33, 34) mit dem Ausgang des die Rampenspannung (U$_R$) erzeugenden Kondensators (C$_\alpha$) verbunden ist.

16. Schaltungsanordnung nach Anspruch 14 oder 15, dadurch gekennzeichnet, daß der zweite Eingang des ersten Komparators (32) und des dritten Komparators (34) mit dem Ausgang des Referenzspannungsgenerators (31) verbunden ist.

17. Schaltungsanordnung nach einem der Ansprüche 14 bis 16, dadurch gekennzeichnet, daß der zweite Eingang des zweiten Komparators (33) mit dem mit der Steuerspannung ($U_\alpha$) beaufschlagten Steuer-Eingang ($P_2$) des integrierten Schaltkreises (IC) verbunden ist.

18. Schaltungsanordnung nach einem der vorangehenden Ansprüche, dadurch gekennzeichnet, daß die Endstufe (40) ein von der Auswerteschaltung (30) angesteuertes Takt-Flip-Flop (41) und einen mit dem Ansteuer-Ausgang ($P_8$) des integrierten Schaltkreises (IC) verbundenen Ausgangs-Verstärker (42) aufweist.

19. Schaltungsanordnung nach einem der vorangehenden Ansprüche, dadurch gekennzeichnet, daß die Spannungsversorgungsschaltung (50) ein Un-Unterspannungserkennungselement (51), ein Versorgungsteil (52), ein Begrenzerteil (53) und eine Begrenzer-Diode (54) aufweist.

## Claims

1. Circuit arrangement for controlling the flow of current in a load (V) that is controlled by a semiconductor element (SE) in accordance with a mains ac voltage ($U_N$), including:

   - a synchronizing circuit (10) for detecting the zero-crossing of the mains ac voltage (UN) and for synchronizing a ramp voltage ($U_R$) with the mains ac voltage ($U_N$),

   - an evaluating circuit (30) for monitoring voltage levels occurring during the control process,

   - an output stage (40) for controlling the semiconductor element (SE),

   - a timing component ($C_\alpha$)

   - and a voltage supply circuit (50),

   characterised in that,

   - there is provided a control circuit (20) for producing differing voltage waveforms of the ramp voltage ($U_R$),

   - the synchronizing circuit (10), the evaluating circuit (30), the output stage (40), the voltage supply circuit (50) and the control circuit (20) are disposed in an integrated circuit (IC)

   - and the current flow through the load (V) is limited to a particular phase angle ($\alpha$) of the mains ac voltage ($U_N$) by means of a reverse phase angle control process.

2. Circuit arrangement in accordance with Claim 1, characterised in that the timing component is a capacitor ($C_\alpha$), from the state of charge of which, the ramp voltage ($U_R$) is formed.

3. Circuit arrangement in accordance with Claim 2, characterised in that the capacitor ($C_\alpha$) is disposed in the integrated circuit (IC).

4. Circuit arrangement in accordance with Claim 2, characterised in that the capacitor ($C_\alpha$) is connected externally to a terminal pin ($P_4$) of the integrated circuit (IC), said pin serving as a control-output or ramp-input.

5. Circuit arrangement in accordance with any of the Claims 1 to 4, characterised in that there is provided an adjusting member (SG) which generates a control voltage ($U_\alpha$) determining the phase angle ($\alpha$), said adjusting member (SG) being connected between a terminal pin ($P_2$) of the integrated circuit (IC) that serves as a control input and a terminal pin ($P_1$) of the integrated circuit (IC) that serves as a reference voltage output.

6. Circuit arrangement in accordance with any of the Claims 1 to 5, characterised in that an externally connected variable resistor ($R_J$) is provided on a terminal pin ($P_3$) of the integrated circuit (IC) that serves as an adjusting input.

7. Circuit arrangement in accordance with any of the Claims 1 to 6, characterised in that the semiconductor element (SE) is connected to a terminal pin ($P_8$) of the integrated circuit (IC) that serves as a control output.

8. Circuit arrangement in accordance with Claim 7, characterised in that the semiconductor element (SE) is an IGBT transistor.

9. Circuit arrangement in accordance with any of the preceding Claims, characterised in that the synchronizing circuit (10) comprises a synchronizing member (11), a zero-crossing detector (12), a storage flip flop (13) and an AND gate (14).

10. Circuit arrangement in accordance with any of the preceding Claims, characterised in that the control circuit (20) comprises a switchable current generator (21), a first switch (22) and a second switch (23).

11. Circuit arrangement in accordance with Claim 10,

characterised in that the output of the current generator (21) is connectible to the capacitor ($C_\alpha$) by means of the first switch (22).

12. Circuit arrangement in accordance with Claim 10 or 11,
characterised in that the output current of the current generator (21) is switchable from a small output current ($I_1$) to a larger output current ($I_1+I_2$) by means of the second switch (23).

13. Circuit arrangement in accordance with any of the Claims 10 to 12, characterised in that the activating/de-activating input of the current generator (21) is connected to the inverting output ($\overline{Q}$) of the storage flip flop (14).

14. Circuit arrangement in accordance with any of the preceding Claims, characterised in that the evaluating circuit (30) comprises a reference voltage generator (31), comparators (32, 33, 34) having different threshold levels ($SW_1$, $SW_2$, $SW_3$) and two logic gates (35, 36).

15. Circuit arrangement in accordance with Claim 14, characterised in that one input of each of the comparators (32, 33, 34) is connected to the output of the capacitor ($C_\alpha$) producing the ramp voltage ($U_R$).

16. Circuit arrangement in accordance with Claim 14 or 15, characterised in that the second input of the first comparator (32) and the second input of the third comparator (34) are connected to the output of the reference voltage generator (31).

17. Circuit arrangement in accordance with any of the Claims 14 to 16, characterised in that the second input of the second comparator (33) is connected to the control input ($P_2$) of the integrated circuit (IC) to which the control voltage ($U\alpha$) is applied.

18. Circuit arrangement in accordance with any of the preceding Claims, characterised in that the output stage (40) comprises a clocking flip flop (41) controlled by the evaluating circuit (30) and an output amplifier (42) connected to the control output ($P_8$) of the integrated circuit (IC).

19. Circuit arrangement in accordance with any of the preceding Claims, characterised in that the voltage supply circuit (50) comprises a low voltage detecting element (51), a power unit (52), a limiter unit (53) and a limiter diode (54).

**Revendications**

1. Circuit de commande de la circulation de courant dans un appareil d'utilisation (V) commandé par un élément de commutation semiconducteur (SE) en fonction d'une tension alternative du réseau ($U_N$), comportant :

- un circuit de synchronisation (10) en vue de la reconnaissance du passage par zéro de la tension alternative du réseau (UN) et en vue de la synchronisation d'une tension de rampe ($U_R$) sur la tension alternative du réseau ($U_N$),
- un circuit d'évaluation (30) en vue de la surveillance de niveaux de tension apparaissant lors de la commande, - un étage terminal (40) en vue de la commande de l'élément de commutation semiconducteur (SE),
- un composant de détermination de temps ($C_\alpha$),
- et un circuit d'alimentation en tension (50),

caractérisé en ce que

- un circuit de commande (20) est prévu en vue de la prescription d'allures de tension différentes de la tension de rampe ($U_R$),
- le circuit de synchronisation (10), le circuit d'évaluation (30), l'étage terminal (40), le circuit d'alimentation en tension (50) et le circuit de commande (20) sont disposés dans un circuit intégré (IC)
- et la circulation du courant dans l'appareil d'utilisation (V) par commande de segment de phase est limitée à un angle de phase déterminé ($\alpha$) de la tension alternative du réseau ($U_N$).

2. Circuit selon la revendication 1, caractérisé en ce que le composant de détermination de temps est un condensateur ($C_\alpha$), par l'état de charge duquel est formée la tension de rampe ($U_R$).

3. Circuit selon la revendication 2, caractérisé en ce que le condensateur ($C_\alpha$) est disposé dans un circuit intégré (IC).

4. Circuit selon la revendication 2, caractérisé en ce que le condensateur ($C_\alpha$) est relié extérieurement à une borne de raccordement ($P_4$) du circuit intégré (IC) servant de sortie de commande et d'entrée de rampe.

5. Circuit selon l'une quelconque des revendications 1 à 4, caractérisé en ce qu'entre une borne de raccordement ($P_2$) servant d'entrée de commande et une borne de raccordement ($P_1$), servant de sortie de tension de référence du circuit intégré (IC), est prévu un élément de réglage commuté (SG), qui génère une tension de commande ($U_\alpha$) déterminant l'angle de phase ($\alpha$).

6. Circuit selon l'une quelconque des revendications 1 à 5, caractérisé en ce qu'à une borne de raccordement ($P_3$) du circuit intégré (IC), servant d'entrée de réglage est prévue une résistance variable ($R_J$) reliée extérieurement.

7. Circuit selon l'une quelconque des revendications 1 à 6, caractérisé en ce que l'élément de commutation semiconducteur (SE) est relié à une borne de raccordement ($P_8$) du circuit intégré (IC) servant de sortie de commande.

8. Circuit selon la revendication 7, caractérisé en ce que l'élément de commutation semiconducteur (SE) est un transistor IGBT.

9. Circuit selon l'une quelconque des revendications précédentes, caractérisé en ce que le circuit de synchronisation (10) comporte un élément de synchronisation (il), un détecteur de zéro (12), une bascule de mémoire (13) et une porte ET (14).

10. Circuit selon l'une quelconque des revendications précédentes, caractérisé en ce que le circuit de commande (20) comporte un générateur de courant commutable (21), un premier commutateur (22) et un second commutateur (23).

11. Circuit selon la revendication (10), caractérisé en ce que la sortie du générateur de courant (21) est reliée, de façon commutable, par l'intermédiaire du premier commutateur (22), au condensateur ($C_\alpha$).

12. Circuit selon la revendication 10 ou 11, caractérisé en ce que le courant de sortie du générateur de courant (21) peut être commuté par l'intermédiaire du second commutateur (23) entre un courant de sortie faible ($I_1$) et un courant de sortie plus intense ($I_1 + I_2$).

13. Circuit selon l'une des revendications 10 à 12, caractérisé en ce que l'entrée d'activation/désactivation du générateur de courant (21) est reliée à la sortie avec inversion ($\overline{Q}$) de la bascule de mémoire (14).

14. Circuit selon l'une des quelconques des revendications précédentes, caractérisé en ce que le circuit d'évaluation (30) comporte un générateur de tension de référence (31), des comparateurs (32, 33, 34) avec des valeurs de seuil différentes ($SW_1$, $SW_2$, $SW_3$) et deux portes logiques (35, 36).

15. Circuit selon la revendication 14, caractérisé en ce que, respectivement, une entrée des comparateurs (32, 33, 34) est reliée à la sortie du condensateur ($C_\alpha$) générant la tension de rampe ($U_R$).

16. Circuit selon la revendication 14 ou 15, caractérisé en ce que la seconde entrée du premier comparateur (32) et du troisième comparateur (34) est reliée à la sortie du générateur de tension de référence (31).

17. Circuit selon l'une quelconque des revendications 14 à 16, caractérisé en ce que la seconde entrée du second comparateur (33) est reliée à l'entrée de commande ($P_2$) du circuit intégré (IC) alimentée par la tension de commande ($U_\alpha$).

18. Circuit selon l'une quelconque des revendications précédentes, caractérisé en ce que l'étage terminal (40) comporte une bascule d'horloge (41) commandée par le circuit d'évaluation et un amplificateur de sortie (42) relié à la sortie de commande ($P_8$) du circuit intégré (IC).

19. Circuit selon l'une quelconque des revendications précédentes, caractérisé en ce que le circuit d'alimentation en tension (50) présente un élément de reconnaissance de mise sous tension (51), une partie d'alimentation (52), un élément limiteur (53) et une diode limiteuse (54).

FIG.1

FIG. 2a

FIG. 2b

FIG. 2c

FIG. 2d

FIG. 2e